# EUROPEAN PATENT SPECIFICATION

(11) **EP 2 790 478 B1**
(45) Date of publication and mention of the grant of the patent: **09.11.2016**
(21) Application number: 13163127.7
(22) Date of filing: 10.04.2013
(51) Int. Cl.: H05K 7/14

(54) **Cable management device**
Kabelführungsvorrichtung
Dispositif de gestion de câbles

(43) Date of publication of application: 15.10.2014
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2005 145 582
- US-A1- 2006 113 433
- US-A1- 2007 017 883
- US-A1- 2009 014 601
- US-A1- 2009 078 834
- US-A1- 2010 193 646
- US-B1- 7 746 667

## Description

### FIELD OF THE INVENTION

The present invention relates to a cable management device, and more particularly, to a support device for cable management.

### BACKGROUND OF THE INVENTION

U.S Patent No. 7,472,795 B2 to Dubon et al., U.S Patent No. 7,654,398 B2 to Bridges et al., U.S Patent No. 7,746,667 B1 to Baiza et al., and U.S Patent No. 7,554,819 B2, U.S Patent No. 7,712,615 B2, U.S Patent No. 8,231,014 B2 and U.S Patent No. 8,251,321 B2 to Chen et al. disclose conventional support devices for cable management and these support devices are referenced when describing the present invention.

However, these conventional support devices are not convenient when being installed and operated. The present invention intends to provide a support device for cable management and improves the shortcomings of the conventional support devices.

### SUMMARY OF THE INVENTION

The present invention relates to a cable management device and comprises a first cable management arm, a second cable management arm, a cable management seat, an extension board, a support seat, a first support member, a second support member, a guide member, a first resilient member and a slide. The cable management seat is pivotably connected between the first and second cable management arms. The extension board is fixed to the cable management seat. The support seat has a support board. A first connection element is connected to the first cable management arm and a second connection element is connected to the second cable management arm. A third connection element is connected to the support seat. The cable management device is connected to a first slide assembly (72) and a second slide assembly (74). The first cable management arm (10) is connected to the first slide assembly (72) by the first connection element (18). The second cable management arm (12) is connected to the first slide assembly (72) by the second connection element (20). The support seat (16) is connected to the second slide assembly (74) by the third connection element (22). The first support member has a first connecting end and a first free end which is located corresponding to the first connecting end. The first support member is pivotably connected to the support seat by the first connecting end. The first support member contacts the support board of the support seat. The second support member has a second connecting end and a second free end which is located corresponding to the second connecting end. The second support member is slidably connected to the first support member. The second support member is extended relative to the first support member to move the second free end away from the first support member. The second free end has a guide member which is extended therefrom and located between the first and second cable management arms. The first resilient member is connected between the first and second support members so as to provide a pull force to the second support member. That is to say, the second support member is pulled by the first resilient member relative to the first support member. A slide is pivotably connected to the extension

board and slidably connected to the second support member. The first cable management arm is connected to a stationary first position by the first connection element. The second cable management arm is connected to a changeable second position by the second connection element. The support seat is connected to a stationary third position by the third connection element. When the second connection element of the second cable management arm is
moved away from the first connection element of the first cable management arm, the cable management seat slides along the second support member by the slide and moves away from the support seat. The slide contacts the guide member and extends the second support member relative to the first support member so as to swing the first support member relative to the support seat.

Preferably, the second support member has a block at the second connecting end and the block is located corresponding to the slide, so that the slide slides between the guide member and the block.

Preferably, the first support member has a first hook and the second support member has a second hook. The first resilient member is connected to the first and second hooks.

Preferably, the support seat, the third connection element and the first support member are pivotably connected to each other by a pivotal member.

Preferably, the support board of the support seat extends substantially horizontally and has a round periphery whose center is the same with the center of the pivotal member. A pin is connected to the first support member and the pin slidably contacts the periphery of the support board.

Preferably, the support board of the support seat has two first stops. A range of the first support member that is pivotable relative to the support seat is restricted between the two first stops.

Preferably, the extension board has a rib extending downward, and the rib contacts the slide.

Preferably, the stop member is connected to the support seat and has two second stops. The third connection element has an extension portion located corresponding to the two second stops. One of the two second stops of the stop member contacts the extension portion of the third connection element.

Preferably, the present invention comprises a first slide assembly which comprises a first stationary rail and a first movable rail which moves longitudinally relative to the first stationary rail. A second slide assembly comprises a second stationary rail and a second movable rail which moves longitudinally relative to the second stationary rail. The first connection element is installed to the first stationary rail and fixedly located at the first position. The second connection element is installed to the first movable rail and located at the second position which is changeable when the first movable rail is moved relative to the first stationary rail. The third connection element is installed to the second stationary rail of the second rail assembly and fixedly located at the third position.

Alternatively, the present invention provides a cable management system and comprises a first slide assembly comprising a first stationary rail and a first movable rail which moves longitudinally relative to the first stationary rail. A second slide assembly comprises a second stationary rail and a second movable rail which moves longitudinally relative to the second stationary rail. A first cable management arm is connected to the first stationary rail of the first slide assembly. A second cable management arm is connected to the first movable rail of the first slide assembly. A cable management seat is pivotably connected between the first and second cable management arms. A support seat is connected to the second stationary rail of the second slide assembly. A first support member has a first connecting end and a first free end which is located corresponding to the first connecting end. The first connecting end is pivotably connected to the support seat. A second support member has a second connecting end and a second free end which is located corresponding to the second connecting end. The second connecting end is slidably connected to the first support member. The second free end has a guide member which is extended therefrom and located between the first and second cable management arms. A first resilient member is connected between the first and second, support members. A slide is pivotably connected to the cable management seat and slidably connected to the second support member. When the first and second slide assemblies are pulled out, the second cable management arm is moved away from the first cable management arm. The slide slides along the second support member and moves away from the support seat. The slide contacts the guide member and extends the second support member relative to the first support member so as to swing the first support member relative to the support seat. When the first and second slide assemblies are retracted, the second cable management arm is retracted relative to the first cable management arm. The second cable management arm contacts the guide member and drives the second support member which moves in response to the first resilient member and relative to the first support member.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the cable management device of the present invention;
Fig. 2 is a perspective view to show a portion of the cable management device of the present invention;
Fig. 3 shows that the cable management device of the present invention is at the retracted position;
Fig. 4 shows that the second connection element of the second cable management arm is moved to a first distance relative to the first connection element of the first cable management arm;
Fig. 5 shows that the second connection element of the second cable management arm is moved to a second distance relative to the first connection element of the first cable management arm;
Fig. 6 shows that the second connection element of the second cable management arm is moved to a third distance relative to the first connection element of the first cable management arm;
Fig. 7 shows that the second connection element of the second cable management arm is moved to a fourth distance relative to the first connection element of the first cable management arm;
Fig. 8 shows the cable management device of the present invention is retracted, and
Fig. 9 shows that the stop member contacts the first support member.

### DETAILED DESCRIPTION OF THE PREFERRED EMBODIMENT

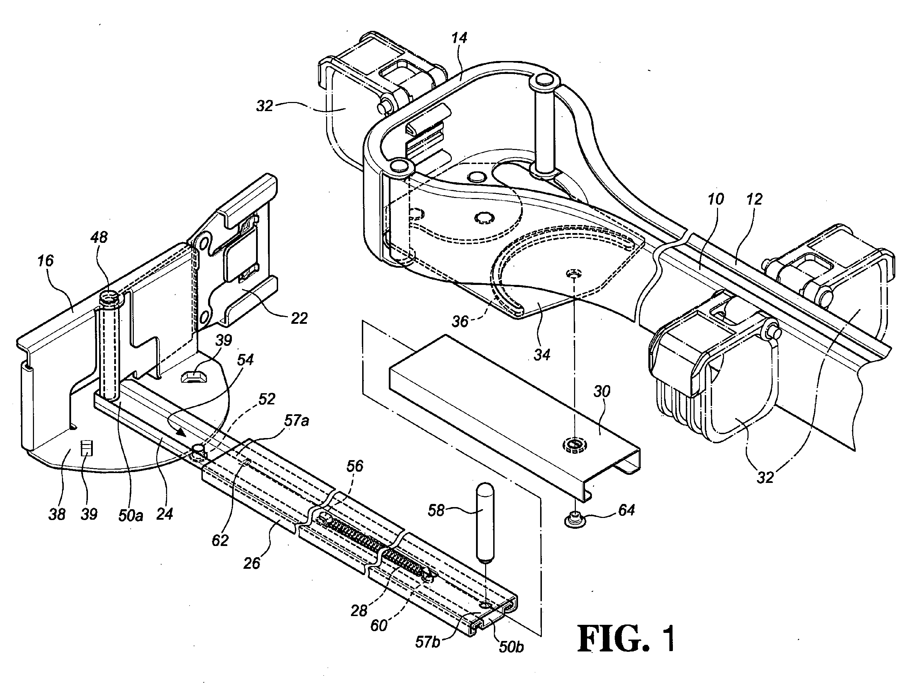

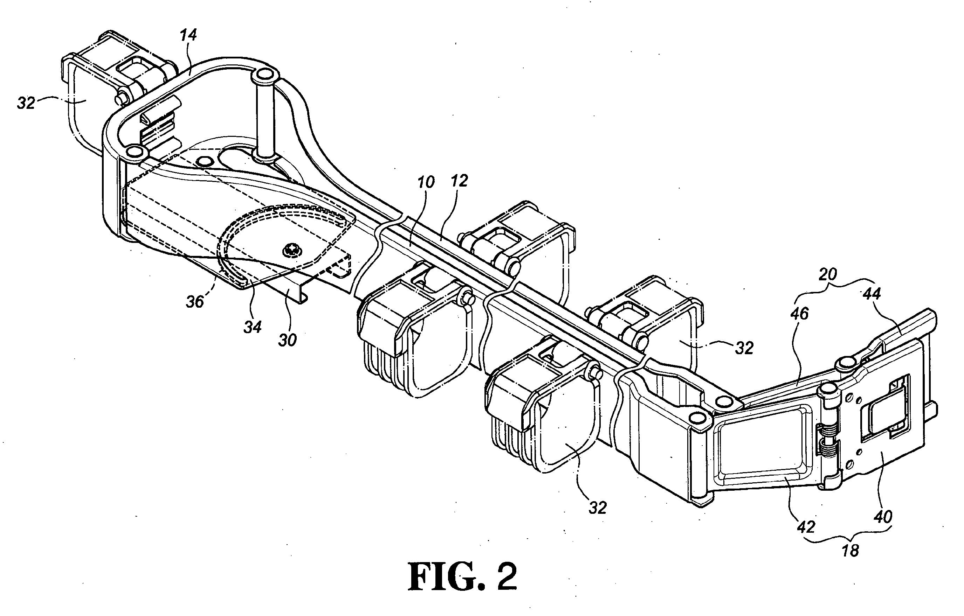

Referring to Figs. 1 and 2, the cable management device of the present invention comprises a first cable management arm 10, a second cable management arm 12, a cable management seat 14, a support seat 16, a first connection element 18, a second connection element 20, a third connection element 22, a first support member 24, a second support member 26, a first resilient member 28, a slide 30 and multiple cable supports 32. Some of the cable supports 32 are located at the first cable management arm 10, the second cable management arm 12 and the cable management seat 14 so that cables (not shown) are put on the cable supports 32.

The cable management seat 14 is pivotably connected between the first and second cable management arms 10, 12. The cable management seat 14 has an extension board 34. In a preferable embodiment, the extension board 34 is a single member and fixed to the underside of the cable management seat 14. Alternatively, the extension board 34 and the cable management seat 14 are a one-piece part so that the extension board 34 can be deemed as a portion of the cable management seat 14. In a preferable embodiment, the extension board 34 has a rib 36 extending downward therefrom.

The support seat 16 has a support board 38. In a preferable embodiment, the support board 38 of the support seat 16 extends substantially horizontally and has a round periphery. Preferably, the periphery of the support board 38 that points the first support member 24 is generally formed as a semi-circular about the pivotal member 48. The support board 38 of the support seat 16 has two first stops 39.

The first connection element 18 is connected to the first cable management arm 10 and has a first engaging member 40 and a first connection member 42 pivotably connected to the first engaging member 40. In a preferable embodiment, the first connection member 42 is pivotably connected to the first cable management arm 10.

The second connection element 20 is connected to the second cable management arm 12 and has a second engaging member 44 and a second connection member 46 pivotably connected to the second engaging member 44. In a preferable embodiment, the second connection member 46 is pivotably connected to the second cable management arm 12.

The third connection element 22 is pivotably connected to the support seat 16 by a pivotal member 48.

The first support member 24 has a first connecting end 50a and a first free end 50b which is located corresponding to the first connecting end 50a. In a preferable embodiment, the first connecting end 50a of the first support member 24 is pivotably connected to the support board 38 of the support seat 16 by the pivotal member 48. The first support member 24 contacts the support board 38 of the support seat 16 and is located between the two first stops 39 so that the range of the first support member 24 that is pivotable relative to the support seat 16 is restricted between the two first stops 39. In a preferable embodiment, a pin 52 is connected to the first support member 24, and the center of the periphery of the support board 38 is the same with the center of the pivotal member 48. When the first support member 24 swings relative to the support seat 16, the pin 52 slidably contacts the periphery of the support board 38. The first support member 24 has a path 54 and a first hook 56, wherein the path 54 is a recessed area extending along the first support member 24, and the first hook 56 extends from the wall of the path 54.

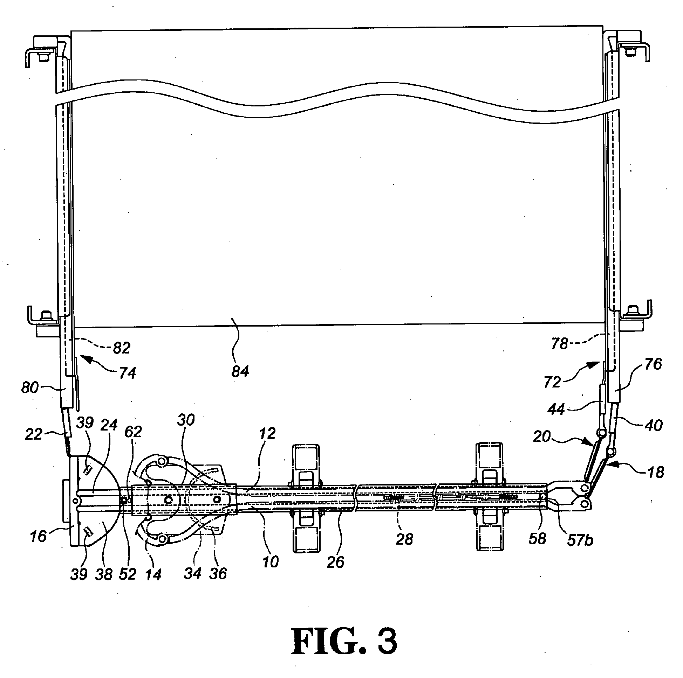

The second support member 26 has a second connecting end 57a and a second free end 57b which is located corresponding to the second connecting end 57a. The second support member 26 is slidably connected to the first support member 24, such as slidably mounted to the first support member 24 so that the second support member 26 is extendable and retractable relative to the first support member 24. When the second support member 26 is extended relative to the first support member 24, the second free end 57b is moved away from the first support member 24. The second free end 57b has a guide member 58 which is extended therefrom and located between the first and second cable management arms 10, 12 as shown in Fig. 3. In a preferable embodiment, the second support member 26 has a second hook 60 extending toward the path 54 of the first support member 24. The second connecting end 57a of the second support member 26 has a block 62, and the block 62 is located corresponding to the slide 30, so that the slide 30 slides between the guide member 58 and the block 62.

The first resilient member 28 is connected between the first and second hooks 56, 60 of the support members 24, 26, so that the second support member 26 is pulled by the first resilient member 28 to the first support member 24 when the second support member 26 is extended relative to the first support member 24. In other words, the second support member 26 is able to respond the force from the first resilient member 28 and move relative to the first support member 24. For example, the second support member 26 is correspondingly retracted to the first support member 24 by the force of the first resilient member 28 from an extended status.

The slide 30 is pivotably connected to the underside of the extension board 34 by a pivot 64, and slidable between guide member 58 of the second support member 26 and the block 62 as shown in Fig. 3. It is noted that the extension board 34 is deemed as a portion of the cable management seat 14, so that the slide 30 pivotably connected to the cable management seat 14 can be considered as the same with the slide 30 pivotably connected to the extention board 34. In a preferable embodiment, the pivot 64 extends through the slide 30 and the extension board 34, and is cooperated with the contact between the slide 30 and the rib 36 of the extension board 34, to let the slide 30 and the extension board 34 be snugly in contact with each other in vertical direction and hence to prevent the first and second cable management arms 10 and 12 from sagging. When the slide 30 moves to the second free end 57b of the second support member 26, the slide 30 contacts the guide member 58 so as to drive the second support member 26 to extend relative to the first support member 24.

Fig. 3 shows the cable management device is connected to the first slide assembly 72 and the second slide assembly 74. The first slide assembly 72 comprises a first stationary rail 76 and a first movable rail 78 which moves longitudinally relative to the first stationary rail 76. The second slide assembly 74 comprises a second stationary rail 80 and a second movable rail 82 which moves longitudinally relative to the second stationary rail 80. A servo equipment 84 is connected to the first movable rail 78 and the second movable rail 82 of the first and second slide assemblies 72, 74, the cables (not shown) of the servo equipment 84 is positioned by the first and second cable management arms 10, 12 and the cable management seat 14. The first cable management arm 10 is connected to the first stationary rail 76 of the first slide assembly 72 by the first engaging member 40 of the first connection element 18 so as to position one end of the first cable management arm 10 at a first position. The second cable management arm 12 is connected to the first movable rail 78 of the first slide assembly 72 by the second engaging member 44 of the second connection element 20 so as to position one end of the second cable management arm 12 at a second position. The second position is changeable when the first movable rail 78 of the first slide assembly 72 moves relative to the first stationary rail 76. The support seat 16 is connected to the second stationary rail 80 of the second slide assembly 74 by the third connection element 22 so as to position at a third position.

As shown in Fig. 3, when the first and second slide assemblies 72, 74 are in retracted status, the second cable management arm 12 moves toward and close to the first cable management arm 10 to form a long cantilever beam so that the center of weight of the whole cable management device is located toward the cable management seat 14. The second support member 26 is retracted to the first support member 24, and the first support member 24 contacts the support board 38 of the support seat 16. The cable management seat 14 is located adjacent to the support seat 16 by the slide 30 mounted to the second support member 26. Therefore, under the retracted status that the second cable management arm 12 located close to the first cable management arm 10, the support seat 16 provides efficient support to the cable management device.

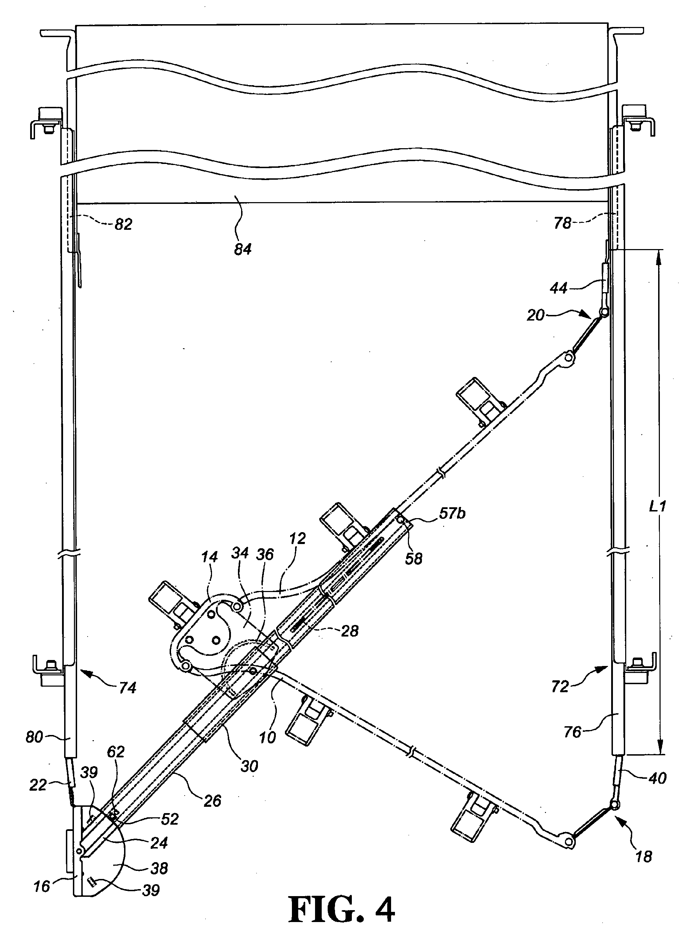

Fig. 4 shows that the first and second movable rails 78, 82 of the first and second slide assemblies 72, 74 are initially extended out, the second connection element 20 of the second cable management arm 12 moves a first distance L1 relative to the first connection element 18 of the first cable management arm 10. The second support member 26 is not yet extended relative to the first support member 24. The cable management seat 14 and the extension board 34 move straightly along the second support member 26 by the slide 30. The cable management seat 14 moves a longitudinal displacement along with the movement of the second cable management arm 12. Therefore, the cable management seat 14 drives the first support member 24 to swing relative to the support seat 16 by the slide 30 and the second support member 26. The swinging of the first support member 24 makes the guide member 58 contact the second cable management arm 12, so that the second free end 57b of the second support member 26 is maintained between the first and second cable management arms 10, 12. In the meanwhile, the slide 30 is pivotable relative to the extension board 34. Under the present status, the center of weight of the whole cable management device is transferred gradually from the support seat 16 to the second support member 26, and the support seat 16 and the second support member 26, including the first support member 24, together provide an efficient support to the cable management device.

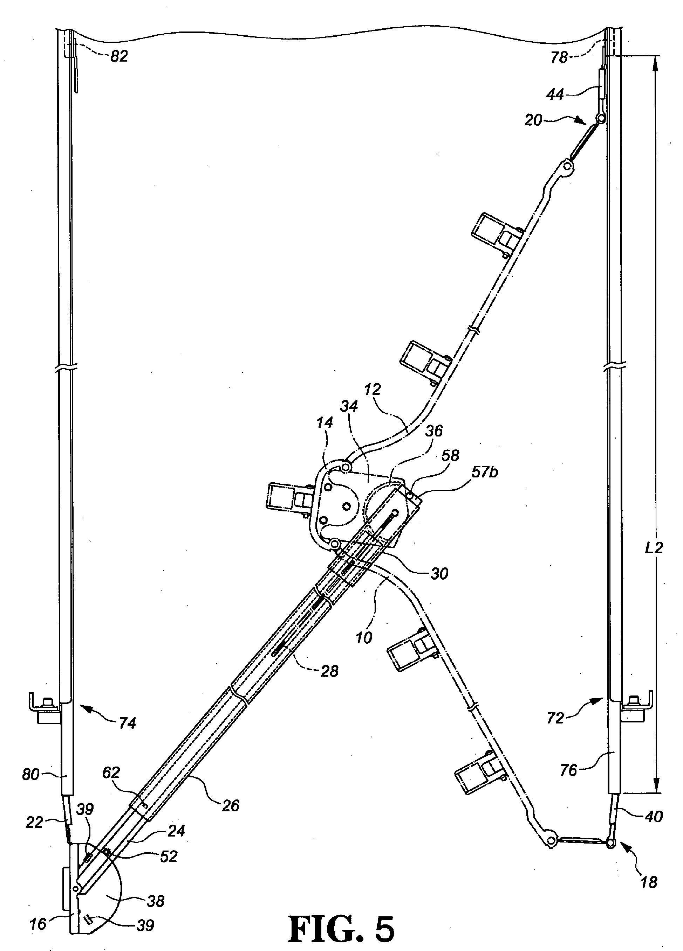

Fig. 5 shows that when the second connection element 20 of the second cable management arm 12 continuously moves to the second distance L2 relative to the first connection element 18 of the first cable management arm 10. The cable management seat 14 and the extension board 34 move along the second support member 26 to the guide member 58 by the slide 30. When the slide 30 contacts the guide member 58, the slide 30 drives the second support member 26 to extend relative to the first support member 24, and the first resilient member 28 is stretched by the second support member 26 to generate a force which is able to pull the second support member 26 back. Because the cable management seat 14 is moves away from the support seat 16 and toward the first slide assembly 72, when the cable management seat 14 is gradually moves close to the center of the transverse distance between the first and second slide assemblies 72, 74, the center of the weight that the cable management device supports is gradually transferred from the support seat 16 to the first and second cable management arms 10, 12 which can be deemed as in the form of shorter cantilever beams. The first and second support members 24, 26 are supported by the support seat 16 and assist to support the weight that the first and second cable management arms 10, 12 support. Therefore, the first and second support members 24, 26, and the first and second cable management arms 10, 12 form a truss-like structure to support the weight of the cable management device.

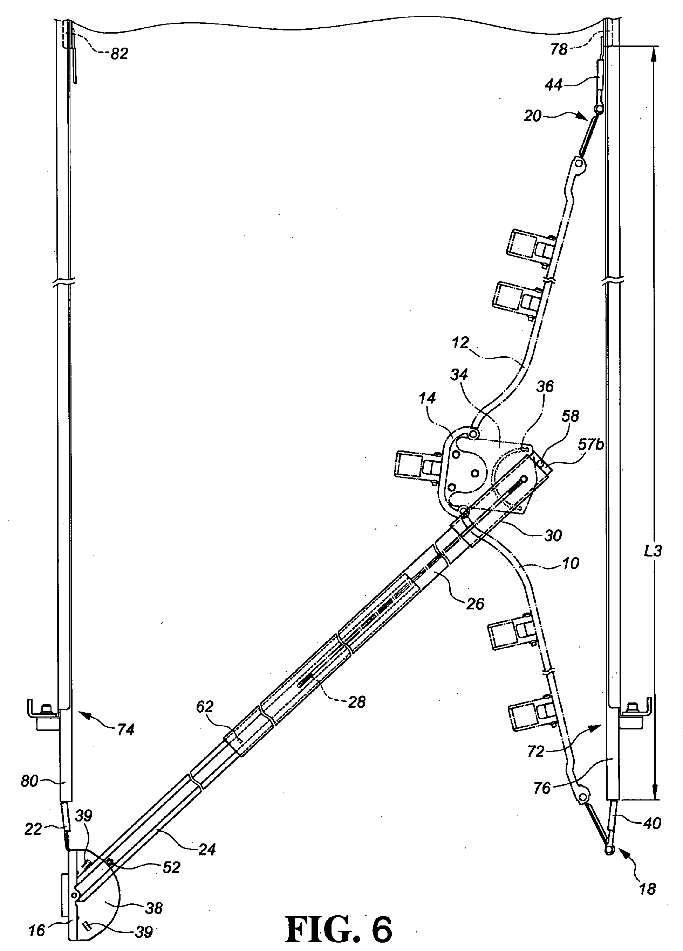

Fig. 6 shows that the second connection element 20 of the second cable management arm 12 continuously moves to the second distance L3 relative to the first connection element 18 of the first cable management arm 10. The cable management seat 14 and the extension board 34 carried by the slide 30 extend the second support member 26 away from the first support member 24, and the first resilient member 28 continuously provides a pull force to the second support member 26. The cable management seat 14 moves over the center of the transverse distance between the first and second slide assemblies 72, 74, and close to the first slide assembly 72. Therefore, the most of the weight of the cable management device will be transferred to and supported by the first and second cable management arms 10, 12 and the weight that the first and second support members 24, 26 support is reduced.

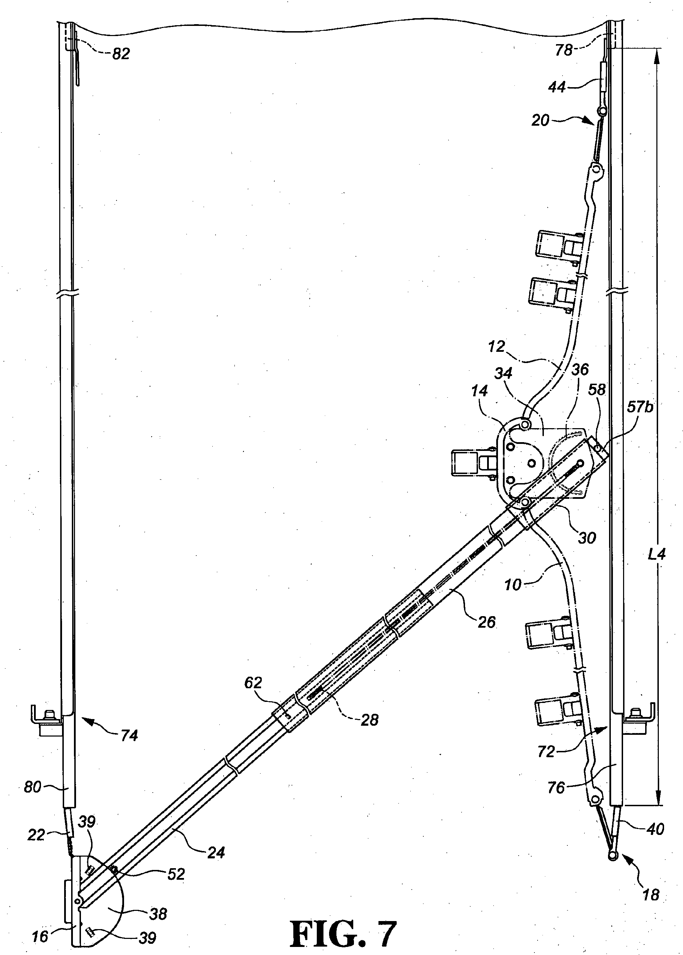

Fig. 7 shows that the second connection element 20 of the second cable management arm 12 moves to the complete extended fourth distance L4 relative to the first connection element 18 of the first cable management arm 10. The cable management seat 14 and the extension board 34 extend completely relative to the first support member 24 by the slide 30 driving the second support member 26. The first support member 24 continuously swings relative to the support seat 16, and the first resilient member 28 continuously apply a pull force to the second support member 26. Under this status, the cable management seat 14 is located very close to the first slide assembly 72, so that the most of the weight of the cable management device is supported by the first and second cable management arms 10, 12 which can be deemed as cantilever beams with the shortest suspension length. The first and second support members 24, 26 are located at the underside of the cable management seat 14 and do not support the weight of the cable management device.

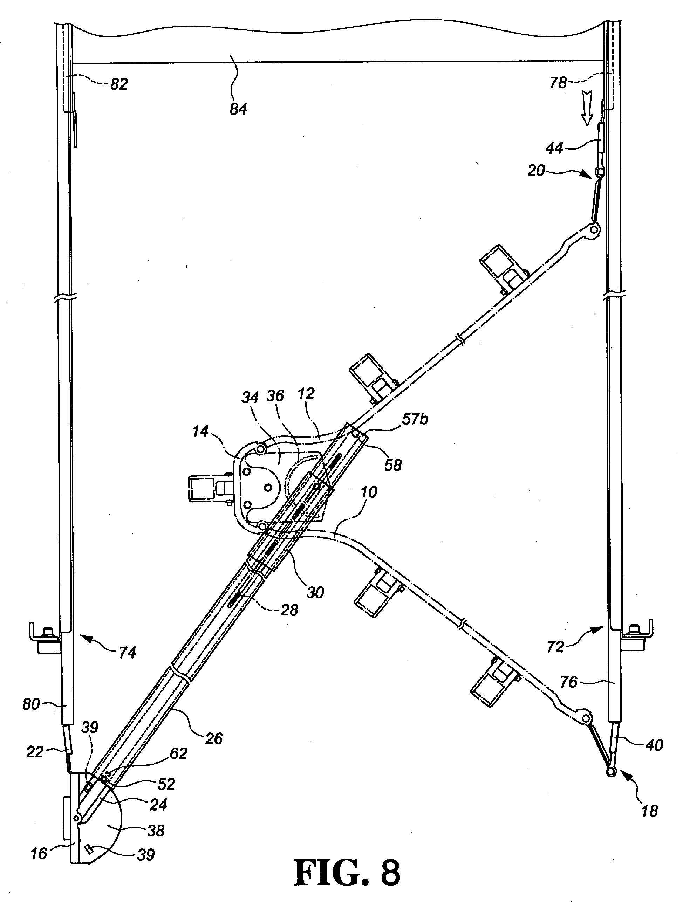

It is noted that during the retracting process of the cable management device, the second support member 26 responds the force of the first resilient member 28 so as to be automatically pulled back relative to the first support member 24. In other words, when the slide 30 moves along the second support member 26 and toward the support seat 16, the second support member 26 is automatically retracted relative to the first support member 24, and the guide member 58 contacts the slide 30, so that the movement of the slide 30 and the second support member 26 are simultaneously proceeded. On the other hand, as shown in Fig. 8, when the second and first support members 26, 24 are retracted, and the slide 30 continuously slides on the second support member 26, the second cable management arm 12 directly contacts the guide member 58 of the second free end 57b of the second support member 26, so that the operation of the overall mechanism of the cable management device is smooth and the first support member 24 swings back to the pre-set retracted position. Besides, when the guide member 58 of the second support member 26 is in contact with the second cable management arm 12, the first stops 39 of the support seat 16 contact the first support member 24 to restrict the first and second support members 24, 26 not overly swing toward the second slide assembly 74 so as not to affect the approach of the second cable management arm 12 toward the first cable management arm 10.

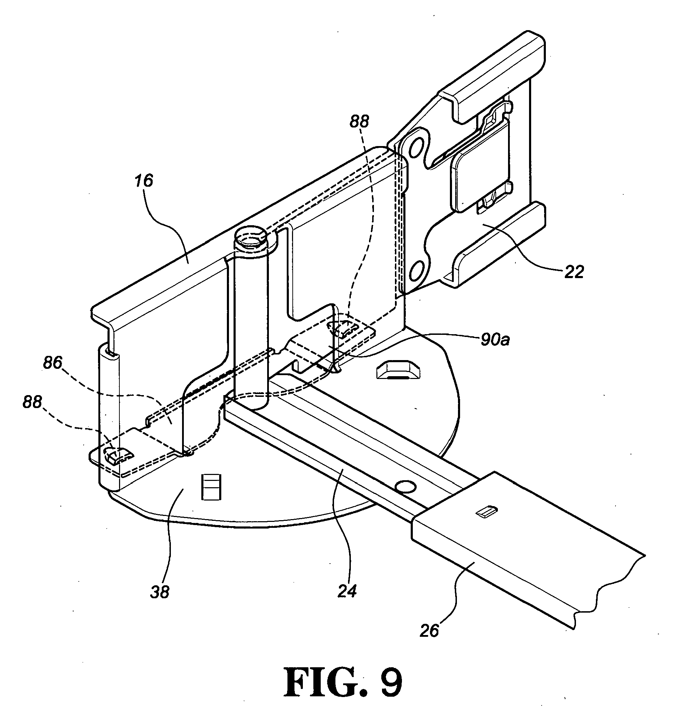

Fig. 9 shows that one preferable embodiment has a stop member 86 which is connected to the support seat 16 and has two second stops 88. The third connection element 22 has an extension portion 90a located corresponding to the two second stops 88. One of the second stops 88 of the stop member 86 contacts the extension portion 90a of the third connection element 22, so that the connection between the support seat 16 and the third connection element 22 can be maintained and does not swing.

The cable management device is firmly and statically supported when in the retracted status as shown in Fig. 3. The weight of the whole cable management device is shared and dynamically supported by the correspondingly varied structure of the cable management device when in extended statuses as shown in Figs. 4-7. Consequently, the cable management device does not overly sagging when the cable management device carried cables.

While we have shown and described the embodiment in accordance with the present invention, it should be clear to those skilled in the art that further embodiments may be made without departing from the scope of the present invention.

## Claims

1. A cable management device comprising: a first cable management arm (10); a second cable management arm (12); a cable management seat (14) pivotably connected between the first and second cable management arms (10, 12); an extension board (34) fixed to the cable management seat (14); a support seat (16) having a support board (38); a first connection element (18) connected to the first cable management arm (10); a second connection element (20) connected to the second cable management arm (12); a third connection element (22) connected to the support seat (16); **characterized in that** the cable management device is connected to a first slide assembly (72) and a second slide assembly (74); the first cable management arm (10) is connected to the first slide assembly (72) by the first connection element (18); the second cable management arm (12) is connected to the first slide assembly (72) by the second connection element (20); and the support seat (16) is connected to the second slide assembly (74) by the third connection element (22); and wherein
a first support member (24) has a first connecting end (50a) and a first free end (50b) which is located corresponding to the first connecting end (50a), the first support member (24) is pivotably connected to the support seat (16) by the first connecting end (50a), the first support member (24) contacts the support board (38) of the support seat (16); a second support member (26) has a second connecting end (57a) and a second free end (57b) which is located corresponding to the second connecting end (57a), the second support member (26) is slidably connected to the first support member (24) so as to extend relative to the first support member (24) to move the second free end (57b) away from the first support member (24), the second free end (57b) has a guide member (58) which is extended therefrom and located between the first and second cable management arms (10, 12); a first resilient member (28) is connected between the first and second support members (24, 26) so as to provide a pull force to the second support member (26); and a slide (30) is pivotably connected to the extension board (34) and slidably connected to the second support member (26); wherein, the first cable management arm (10) is connected to a stationary first position by the first connection element (18), the second cable management arm (12) is connected to a changeable second position by the second connection element (20), the support seat (16) is connected to a stationary third position by the third connection element (22), when the second connection element (20) of the second cable management arm (12) is moved away from the first connection element (18) of the first cable management arm (10), the cable management seat (14) slides along the second support member (26) by the slide (30) and moves away from the support seat (16), the slide (30) contacts the guide member (58) and extends the second support member (26) relative to the first support member (24) so as to swing the first support member (24) relative to the support seat (16).

2. The device as claimed in claim 1, wherein the second support member (26) has a block (62) at the second connecting end (57a), and the block (62) is located corresponding to the slide (30), so that the slide (30) slides between the guide member (58) and the block (62).

3. The device as claimed in claim 1 or 2, wherein the first support member (24) has a first hook (56) and the second support member (26) has a second hook (60), the first resilient member (28) is connected to the first and second hooks (56, 60).

4. The device as claimed in any one of claims 1-3, wherein the support seat (16), the third connection element (22) and the first support member (24) are pivotably connected to each other by a pivotal member (48).

5. The device as claimed in claim 4, wherein the support board (38) of the support seat (16) extends substantially horizontally and has a round periphery whose center of circle is the same with the center of the pivotal member (48), a pin (52) connected to the first support member (24), and the pin (52) slidably contacts the periphery of the support board (38).

6. The device as claimed in claim 4 or 5, wherein the support board (38) of the support seat (16) has two first stops (39), a range of the first support member (24) that is pivotable relative to the support seat (16) is restricted between the two first stops (39).

7. The device as claimed in any one of claims 1-6, wherein the extension board (34) has a rib (36) extending downward, and the rib (36) contacts the slide (30).

8. The device as claimed in any one of claims 1-7, further comprising a stop member (86) connected to the support seat (16) and having two second stops (88), wherein the third connection element (22) has an extension portion (90a) located corresponding to the two second stops (88), one of the two second stops (88) of the stop member (86) contacts the extension portion (90a) of the third connection element (22).

9. The device as claimed in any one of claims 1-8 further comprising a first slide assembly (72) which comprises a first stationary rail (76) and a first movable rail (78) which moves longitudinally relative to the first stationary rail (76), a second slide assembly (74) comprising a second stationary rail (80) and a second movable rail (82) which moves longitudinally relative to the second stationary rail (80), wherein the first connection element (18) is installed to the first stationary rail (76) and fixedly located at the first position, the second connection element (20) is installed to the first movable rail (78) and located at the second position which is changeable when the first movable rail (78) is moved relative to the first stationary rail (76), the third connection element (22) is installed to the second stationary rail (80) of the second rail assembly (74) and fixedly located at the third position.

10. The device as claimed in any one of claims 1-9, wherein when the second connection element (20) of the second cable management arm (12) is retraced toward the first connection element (18) of the first cable management arm (10), the second cable management arm (12) is retracted relative to the first cable management arm (10), the second cable management arm (12) contacts the guide member (58) and drives the second support member (26) which moves in response to the first resilient member (28) and relative to the first support member (24).

## Patentansprüche

1. Eine Kabelhaltevorrichtung, umfassend: einen ersten Kabelhaltearm (10); einen zweiten Kabelhaltearm (12); einen Kabelhaltesitz (14), der drehgelenkig zwischen dem ersten und zweiten Kabelhaltearm (10, 12) befestigt ist; ein Anlegeplättchen (34), das am Kabelhaltesitz (14) befestigt ist; einen Stützsitz (16) mit einem Stützplättchen (38); ein erstes Verbindungselement (18), das am ersten Kabelhaltearm (10) befestigt ist; ein zweites Verbindungselement (20), das am zweiten Kabelhaltearm (12) befestigt ist; ein drittes Verbindungselement (22), das am Stützsitz (16) befestigt ist; **dadurch gekennzeichnet, dass** die Kabelhaltevorrichtung an einem ersten Schlitten (72) und an einem zweiten Schlitten (74) befestigt ist; der erste Kabelhaltearm (10) mit dem ersten Verbindungselement (18) am ersten Schlitten (72) befestigt ist; der zweite Kabelhaltearm (12) mit dem zweiten Verbindungselement (20) am ersten Schlitten (72) befestigt ist; und der Stützsitz (16) mit dem dritten Verbindungselement (22) am zweiten Schlitten (74) befestigt ist; und wobei
ein erstes Stützglied (24) ein erstes Anschlussende (50a) und ein erstes freies Ende (50b) aufweist, das in Übereinstimmung mit dem ersten Elnschlussende (50a) angeordnet ist; das erste Stützglied (24) mit dem ersten Anschlussende (50a) drehgelenkig am Stützsitz (16) befestigt ist; das erste Stützglied (24) mit dem Stützplättchen (38) des Stützsitzes (16) in Berührung kommt; ein zweites Stützglied (26) ein zweites Anschlussende (57a) und ein zweites freies Ende (57b) aufweist, das in Übereinstimmung mit dem zweiten Anschlussende (57a) angeordnet ist; das zweite Stützglied (26) gleitbar am ersten Stützglied (24) befestigt ist, um am ersten Stützglied (24) auszustrecken und somit das zweite freie (57b) vom ersten Stützglied (24) wegzubewegen; das zweite freie Ende (57b) ein Führungsglied (58) aufweist, das sich von diesem erstreckt und zwischen dem ersten und zweiten Kabelhaltearm (10, 12) angeordnet ist; eine erste Feder (28) zwischen dem ersten und zweiten Stützglied (24, 26) befestigt ist, um eine Zugkraft auf das zweite Stützglied (26) auszuüben; ein Schieber (30) drehgelenkig am Anlegeplättchen (34) und gleitbar am zweiten Stützglied (26) befestigt ist; wobei der erste Kabelhaltearm (10) mit dem ersten Verbindungselement (18) in einer stationären ersten Position befestigt ist; der zweite Kabelhaltearm (12) mit dem zweiten Verbindungselement (20) in einer veränderbaren zweiten Position befestigt ist; der Stützsitz (16) mit dem dritten Verbindungselement (22) in einer stationären dritten Position befestigt ist; beim Wegbewegen des zweiten Verbindungselements (20) des zweiten Kabelhaltearms (12) vom ersten Verbindungselement (18) des ersten Kabelhaltearms (10) der Kabelhaltesitz (14) mit dem Schieber (30) am zweiten Stützglied (26) entlang geschoben und vom Stützsitz (16) wegbewegt wird; der Schieber (30) mit dem Führungsglied (58) in Berührung kommt und sich zum zweiten Stützglied (26) relativ zum ersten Stützglied (24) erstreckt, um das erste Stützglied (24) am Stützsitz (16) zu schwenken.

2. Die Vorrichtung nach Anspruch 1, wobei das zweite Stützglied (26) einen Block (62) am zweiten Anschlussende (57a) aufweist; und der Block (62) in Übereinstimmung mit dem Schieber (30) angeordnet ist, so dass der Schieber (30) zwischen dem Führungsglied (58) und dem Block (62) geschoben wird.

3. Die Vorrichtung nach Anspruch 1 oder 2, wobei das erste Stützglied (24) mit einem ersten Haken (56) und das zweite Stützglied (26) mit einem zweiten Haken (60) gebildet sind, während die erste Feder (28) am ersten und zweiten Haken (56, 60) befestigt ist.

4. Die Vorrichtung nach einer der Ansprüche 1-3, wobei der Stützsitz (16), das dritte Verbindungselement (22) und das erste Stützglied (24) mit einem Gelenkteil (48) drehgelenkig miteinander befestigt sind.

5. Die Vorrichtung nach Anspruch 4, wobei sich das Stützplättchen (38) des Stützsitzes (16) im Wesentlichen horizontal erstreckt und eine runde Peripherie aufweist, deren Mitte der Mitte des Gelenkteils (48) entspricht; ein Stift (52) am ersten Stützglied (24) befestigt ist, wobei der Stift (52) gleitbar mit der Peripherie des Stützplättchens (38) in Berührung kommt.

6. Die Vorrichtung nach Anspruch 4 oder 5, wobei das Stützplättchen (38) des Stützsitzes (16) mit zwei ersten Anschlägen (39) gebildet ist; eine Reihe des ersten Stützgliedes (24), das drehgelenkig am Stützsitz (16) befestigt ist, zwischen den beiden ersten Anschlägen (39) begrenzt ist.

7. Die Vorrichtung nach einem der Ansprüche 1-6, wobei das Anlegeplättchen (34) eine sich nach unten erstreckende Rippe (36) aufweist und diese Rippe (36) mit dem Schieber (30) in Berührung kommt.

8. Die Vorrichtung nach einem der Ansprüche 1-7, weiter umfassend einen Anschlagteil (86), der am Stützsitz (16) befestigt ist und zwei zweite Anschläge (88) aufweist; wobei das dritte Verbindungselement (22) einen Verlängerungsteil (90a) aufweist, der in Übereinstimmung mit den beiden zweiten Anschlägen (88) angeordnet ist; einer der beiden zweiten Anschläge (88) des Anschlagteils (86) mit dem Verlängerungsteil (90a) des dritten Verbindungselements (22) in Berührung kommt.

9. Die Vorrichtung nach einem der Ansprüche 1-8, weiter umfassend einen ersten Schlitten (72), der eine erste stationäre Schiene (76) und eine erste bewegliche Schiene (78) umfasst, die der Länge nach an der ersten stationären Schiene (76) bewegt wird; ein zweiter Schlitten (74), der eine zweite stationäre Schiene (80) und eine zweite bewegliche Schiene (82) umfasst, die der Länge nach an der zweiten stationären Schiene (80) bewegt wird; das erste Verbindungselement (18) an der ersten stationären Schiene (76) befestigt und fest in der ersten Position angeordnet ist; das zweite Verbindungselement (20) an der ersten beweglichen Schiene (78) befestigt und in der zweiten Position angeordnet ist, die veränderbar ist, wenn die erste bewegliche Schiene (78) an der ersten stationären Schiene (76) bewegt wird; das dritte Verbindungselement (22) an der zweiten stationären Schiene (80) des zweiten Schlitten (74) befestigt und fest in der dritten Position angeordnet ist.

10. Die Vorrichtung nach einem der Ansprüche 1-9, wobei beim Zurücklaufen des zweiten Verbindungselements (20) des zweiten Kabelhaltearms (12) zum ersten Verbindungselement (18) des ersten Kabelhaltearms (10) der zweite Kabelhaltearm (12) am ersten Kabelhaltearm (10) zurückgelaufen wird; der zweite Kabelhaltearm (12) mit dem Führungsglied (58) in Berührung kommt und das zweite Stützglied (26) antreibt, das auf Reaktion der ersten Feder (28) und am ersten Stützglied (24) bewegt wird.

## Revendications

1. Dispositif de gestion de câbles, **caractérisé par le fait qu'**il comprend:
un premier bras de gestion de câbles (10) ; un second bras de gestion de câbles (12) ; un siège de gestion de câbles (14) raccordé de façon pivotante entre les premier et second bras de gestion de câbles (10, 12) ; une carte d'extension (34) fixée au siège de gestion de câbles (14) ; un siège de support (16) présentant une plaque de support (38) ; un premier élément de raccordement (18) raccordé au premier bras de gestion de câbles (10) ; un deuxième élément de raccordement (20) raccordé au second bras de gestion de câbles (12) ; un troisième élément de raccordement (22) raccordé au siège de support (16) ; **caractérisé en ce que** le dispositif de gestion de câbles est raccordé à un premier ensemble coulissant (72) et à un second ensemble coulissant (74) ; le premier bras de gestion de câbles (10) est raccordé au premier ensemble coulissant (72) par le premier élément de raccordement (18) ; le second bras de gestion de câbles (12) est raccordé au premier ensemble coulissant (72) par le deuxième élément de raccordement (20) ; et le siège de support (16) est raccordé au second ensemble coulissant (74) par le troisième élément de raccordement (22) ; et dans lequel
un premier élément de support (24) présente une première extrémité de raccordement (50a) et une première extrémité libre (50b) qui est située en correspondance avec la première extrémité de raccordement (50a), le premier élément de support (24) est raccordé de manière pivotante au siège de support (16) par la première extrémité de raccordement (50a), le premier élément de support (24) est en contact avec la plaque de support (38) du siège de support (16) ; un second élément de support (26) présente une seconde extrémité de raccordement (57a) et une seconde extrémité libre (57b) qui est située en correspondance avec la seconde extrémité de raccordement (57a), le second élément de support (26) est raccordé de manière coulissante au premier élément de support (24) de manière à se prolonger par rapport au premier élément de support (24) pour déplacer la seconde extrémité libre (57b) à l'écart du premier élément de support (24), la seconde extrémité libre (57b) présente un élément de guidage (58) qui est prolongé à partir de celle-ci et situé entre les premier et second bras de gestion de câbles (10, 12) ; un premier élément élastique (28) est raccordé entre les premier et second éléments de support (24, 26) de manière à fournir une force de traction au second élément de support (26) ; et une glissière (30) est raccordée de manière pivotante à la carte d'extension (34) et raccordée de manière coulissante au second élément de support (26) ; dans lequel, le premier bras de gestion de câbles (10) est raccordé à une première position stationnaire par le premier élément de raccordement (18), le second bras de gestion de câbles (12) est raccordé à une deuxième position changeable par le deuxième élément de raccordement (20), le siège de support (16) est raccordé à une troisième position stationnaire par le troisième élément de raccordement (22), lorsque le deuxième élément de raccordement (20) du second bras de gestion de câbles (12) est déplacé à l'écart du premier élément de raccordement (18) du premier bras de gestion de câbles (10), le siège de gestion de câbles (14) coulisse le long du second élément de support (26) par la glissière (30) et se déplace à l'écart du siège de support (16), la glissière (30) est en contact avec l'élément de guidage (58) et prolonge le second élément de support (26) par rapport au premier élément de support (24) de manière à faire pivoter le premier élément de support (24) par rapport au siège de support (16).

2. Le dispositif tel revendiqué selon la revendication 1, **caractérisée par le fait que** le second élément de support (26) présente un bloc (62) à la seconde extrémité de raccordement (57a), et le bloc (62) est situé en correspondance avec la glissière (30), de sorte que la glissière (30) coulisse entre l'élément de guidage (58) et le bloc (62).

3. Le dispositif tel revendiqué selon la revendication 1 ou 2, **caractérisée par le fait que** le premier élément de support (24) présente un premier crochet (56) et le second élément de support (26) présente un second crochet (60), le premier élément élastique (28) est raccordé aux premiers et second crochets (56, 60).

4. Le dispositif tel revendiqué dans l'une quelconque des revendications 1-3, **caractérisée par le fait que** le siège de support (16), le troisième élément de raccordement (22) et le premier élément de support (24) sont raccordés de manière pivotante entre eux par un élément pivotant (48).

5. Le dispositif tel revendiqué selon la revendication 4, **caractérisée par le fait que** la plaque de support (38) du siège de support (16) se prolonge essentiellement horizontalement et présente une périphérie ronde dont le centre du cercle est le même que le centre de l'élément pivotant (48), un axe (52) raccordé au premier élément de support (24), et l'axe (52) est en contact de manière coulissante avec la périphérie de la plaque de support (38).

6. Le dispositif tel revendiqué selon la revendication 4 ou 5, **caractérisée par le fait que** la plaque de support (38) du siège de support (16) présente deux premières butées (39), une étendue du premier élément de support (24) qui est pivotante par rapport au siège de support (16) est confinée entre les deux premières butées (39).

7. Le dispositif tel revendiqué dans l'une quelconque des revendications 1-6, **caractérisée par le fait que** la carte d'extension (34) présente une nervure (36) se prolongeant vers le bas, et la nervure (36) est en contact avec la glissière (30).

8. Le dispositif tel revendiqué dans l'une quelconque des revendications 1-7, **caractérisé par le fait qu'**il comprend en outre un élément de butée (86) raccordé au siège de support (16) et présentant deux secondes butées (88), dans lequel le troisième élément de raccordement (22) présente une partie de prolongement (90a) située en correspondance avec les deux secondes butées (88), l'une des deux secondes butées (88) de l'élément de butée (86) est en contact avec la partie de prolongement (90a) du troisième élément de raccordement (22).

9. Le dispositif tel revendiqué dans l'une quelconque des revendications 1-8 **caractérisé par le fait qu'**il comprend en outre un premier ensemble coulissant (72) qui comprend un premier rail stationnaire (76) et un premier rail mobile (78) qui se déplace longitudinalement par rapport au premier rail stationnaire (76), un second ensemble coulissant (74) comprenant un second rail stationnaire (80) et un second rail mobile (82) qui se déplace longitudinalement par rapport au second rail stationnaire (80), dans lequel le premier élément de raccordement (18) est placé sur le premier rail stationnaire (76) et situé de manière fixe sur la première position, le deuxième élément de raccordement (20) est placé sur le premier rail mobile (78) et situé sur la seconde position qui est changeable lorsque le premier rail mobile (78) est déplacé par rapport au premier rail stationnaire (76), le troisième élément de raccordement (22) est placé sur le second rail stationnaire (80) du second ensemble de rails (74) et situé de manière fixe sur la troisième position.

10. Le dispositif tel revendiqué dans l'une quelconque des revendications 1-9, **caractérisée par le fait que** lorsque le deuxième élément de raccordement (20) du second bras de gestion de câbles (12) est rétracté vers le premier élément de raccordement (18) du premier bras de gestion de câbles (10), le second bras de gestion de câbles (12) est rétracté par rapport au premier bras de gestion de câbles (10), le second bras de gestion de câbles (12) est en contact avec l'élément de guidage (58) et entraîne le second élément de support (26) qui se déplace en réponse au premier élément élastique (28) et par rapport au premier élément de support (24).
